# FASCICULE DE BREVET EUROPEEN

(11) **EP 3 353 250 B1**
(45) Date de publication et mention de la délivrance du brevet: **05.06.2019**
(21) Numéro de dépôt: 16781840.0
(22) Date de dépôt: 20.09.2016
(51) Int. Cl.: C09D 127/16, C08F 214/22, C08J 5/18, H01L 51/40, H01L 37/02, H01L 41/193

(54) **TERPOLYMÈRES DU FLUORURE DE VINYLIDÈNE, DU TRIFLUOROÉTHYLÈNE ET DU 1,3,3,3-TÉTRAFLUOROPROPÈNE**
VINYLIDENFLUORID-TRIFLUOROETHYLEN-1,3,3,3-TETRAFLUOROPROPEN-TERPOLYMERE
TERPOLYMERS OF VINYLIDENE FLUORIDE, TRIFLUOROETHYLENE AND 1,3,3,3-TETRAFLUOROPROPENE

(30) Priorité: 23.09.2015 FR 1558962
(43) Date de publication de la demande: 01.08.2018
(73) Titulaire: Arkema France, 92700 Colombes (FR); Centre National de la Recherche Scientifique, 75016 Paris 14 (FR); Université de Montpellier, 34090 Montpellier (FR); Ecole Nationale Supérieure de Chimie de Montpellier, 34296 Montpellier (FR)
(72) Inventeur: DOMINGUES DOS SANTOS, Fabrice, 75003 Paris (FR); LANNUZEL, Thierry, 69100 Villeurbanne (FR); SOULESTIN, Thibaut, 69007 Lyon (FR); AMEDURI, Bruno, 34000 Montpellier (FR); LADMIRAL, Vincent, 34080 Montpellier (FR)
(74) Mandataire: Albani, Dalila
(86) Numéro de dépôt international: PCT/FR2016/052378
(87) Numéro de publication internationale: WO 2017/051109

(56) Documents cités:
- WO-A1-2013/160621
- RONALD C. G. NABER ET AL: "Organic Nonvolatile Memory Devices Based on Ferroelectricity", ADVANCED MATERIALS, vol. 22, no. 9, 5 mars 2010 (2010-03-05), pages 933-945, XP055073941, ISSN: 0935-9648, DOI: 10.1002/adma.200900759

## Description

### DOMAINE DE L'INVENTION

La présente invention concerne des terpolymères du fluorure de vinylidène (VDF), du trifluoroéthylène (TrFE) et du 1,3,3,3-tétrafluoropropène (appelé aussi HFO-1234ze ou 1234ze), des procédés de préparation de ces terpolymères ainsi que leurs applications.

### ARRIERE-PLAN TECHNIQUE

Les polymères fluorés représentent une classe de composés ayant des propriétés remarquables pour un grand nombre d'applications, depuis la peinture ou les revêtements protecteurs spéciaux jusqu'aux joints d'étanchéité, en passant par l'optique, la microélectronique, l'énergie et les technologies membranaires. Parmi ces polymères fluorés, les terpolymères comprenant du VDF et du TrFE sont particulièrement intéressants en raison de leur électroactivité.

L'article d'Higashihata et al. dans Ferroelectrics 32:85-92 (1981) décrit la copolymérisation du VDF avec du TrFE ainsi que l'évaluation des propriétés piezoélectriques des copolymères poly(VDF-*co*-TrFE).

L'article de Chung et al. dans Macromolecules 35:7678-7684 (2002) et le document US 2008/0081195 A1 décrivent la terpolymérisation du VDF, du TrFE et d'un troisième termonomère chloré de type chlorotrifluoroéthylène (CTFE) ou 2-chloro-1,1-difluoroéthylène (CDFE) pour l'obtention en une étape de terpolymères poly(VDF-*ter*-TrFE-*ter*-M) dont les propriétés d'électroactivité ont été évaluées.

Les articles de Wang et al. dans Macromolecules 39:4268-4271 (2006), de Lu et al. dans Macromolecules 39:6962-6968 (2006), de Lu et al. dans J. Am. Chem. Soc. 128:8120-8121 (2006) et de Zhang et al. dans Macromolecules 40:783-785 (2007) décrivent des terpolymères du VDF, du TrFE et de chlorotrifluoroéthylène (CTFE) ainsi que leur préparation en deux étapes par une copolymérisation du VDF avec du CTFE suivie de la réduction des atomes de chlore des unités de CTFE.

L'article de Zhu et al. dans Macromolecules 45:2937-2954 (2012) décrit l'électroactivité de plusieurs polymères à base de VDF, et notamment de terpolymères poly(VDF-*ter*-TrFE-*ter*-CFE), poly(VDF-*ter*-TrFE-*ter*-CDFE), poly(VDF-*ter*-TrFE-*ter*-CTFE) et poly(VDF-*ter*-TrFE-*ter*-HFP).

Par ailleurs, il a été également proposé des techniques de copolymérisation radicalaire contrôlée, comme dans le document WO 2013/160621 A1, c'est-à-dire permettant d'obtenir un contrôle de la masse molaire et de l'indice de polymolécularité des polymères.

Le document US 6,355,749 décrit la préparation de terpolymères du VDF, du TrFE et d'un termonomère tel que le CTFE ou l'hexafluoropropène (HFP), selon un procédé de copolymérisation contrôlée au moyen d'organoboranes en présence d'oxygène. De même, l'article de Chung et al. dans Macromolecules 35:7678-7684 (2002) décrit la fabrication de terpolymères de VDF, de TrFE et d'un termonomère chloré (CTFE, CDFE, VC ou chlorure de vinyle, CFE ou 1,1-chlorofluoroéthylène) également selon une copolymérisation contrôlée au moyen d'organoboranes. Cette technique est difficile à mettre en oeuvre en pratique en raison du coût élevé des organoboranes et des risques d'explosion qu'ils engendrent.

Il existe toutefois un besoin de développer de nouveaux terpolymères électroactifs à base de VDF, de TrFE et d'un termonomère. Un des facteurs limitant fortement l'introduction de nouveaux termonomères est la réactivité chimique lors de la polymérisation de ces derniers, aboutissant à la synthèse de terpolymères hétérogènes. Afin d'obtenir des terpolymères donnant satisfaction, des stratégies de polymérisation complexes et donc couteuses sont mises en place. Par ailleurs, certains termonomères, comme le 3,3,3-trifluoropropene et le 2-chloro-3,3,3-trifluoropropène ont une faible réactivité due à la stabilité des radicaux formés et/ou à leur encombrement stérique. Ces limites propres aux monomères et donc indépendantes du procédé de polymérisation radicalaire conduisent à des rendements faibles ou à des temps de réaction très longs.

La présente invention se propose de remédier à ces inconvénients, en fournissant un nouveau terpolymère à base de VDF, TrFE et 1,3,3,3-tétrafluoropropène : poly(VDF-*ter*-TrFE-*ter*-1234ze) qui possède des propriétés d'électroactivité et qui est synthétisé au moyen d'un procédé simple et rapide. Il a été trouvé de manière surprenant que le 1,3,3,3-tétrafluoropropène ne présente pas les problèmes de réactivité précédemment cités et permet donc de résoudre les problèmes liés au coût et à la mise en oeuvre des procédés. Dans le cadre de l'invention, le termonomère s'incorpore de manière homogène durant toute la polymérisation, c'est-à-dire que toutes les chaînes ont la même composition en termonomère. Celui-ci est distribué aléatoirement le long des chaînes polymères, ce qui permet d'obtenir un terpolymère poly(VDF-*ter*-TrFE-*ter*-1234ze) ayant une composition similaire au mélange initial de monomères.

### RESUME DE L'INVENTION

L'invention concerne en premier lieu un terpolymère de fluorure de vinylidène (VDF), de trifluoroéthylène (TrFE) et de 1,3,3,3-tétrafluoropropène (appelé aussi HFO-1234ze ou 1234ze).

Selon un mode de réalisation, le terpolymère, selon l'invention, a la composition suivante (en moles) :
- une proportion de motifs issus du monomère fluorure de vinylidène de 40 à 90 %, de préférence de 50 à 80 % ;
- une proportion de motifs issus du monomère trifluoroéthylène de 5 à 50 %, de préférence de 10 à 40 % ; et
- une proportion de motifs issus du monomère 1,3,3,3-tétrafluoropropène de 0,1 à 15 %, de préférence de 0,5 à 10 %.

L'invention a également pour objet un procédé de préparation du terpolymère poly(VDF-*ter*-TrFE-*ter*-1234ze) comprenant une étape de terpolymérisation d'un mélange réactionnel de VDF, TrFE et 1234ze. De préférence, cette réaction est une polymérisation radicalaire conventionnelle.

Selon un premier mode de réalisation, ledit terpolymère est préparé par un procédé de polymérisation radicalaire en solution, comprenant une étape de terpolymérisation d'un mélange réactionnel de fluorure de vinylidène, de trifluoroéthylène et de 1,3,3,3-tétrafluoropropène en présence d'un amorceur radicalaire et d'un solvant.

Selon un autre mode de réalisation, ledit terpolymère est préparé par un procédé de polymérisation radicalaire en suspension, comprenant une étape de terpolymérisation d'un mélange réactionnel de fluorure de vinylidène, de trifluoroéthylène et de 1,3,3,3-tétrafluoropropène en présence d'eau, d'un amorceur radicalaire, éventuellement d'un agent de dispersion et, éventuellement, d'un agent de transfert de chaine.

L'invention a également pour objet un film ou une membrane mis en forme à partir d'au moins un terpolymère poly(VDF-*ter*-TrFE-*ter*-1234ze).

L'invention a également pour objet un dispositif piézoélectrique comprenant un tel film.

L'invention a également pour objet un dispositif ferroélectrique comprenant un tel film.

L'invention a également pour objet un dispositif pyroélectrique comprenant un tel film.

L'invention a également pour objet un dispositif électroactif comprenant un tel film.

L'invention a également pour objet un revêtement comprenant un tel film.

La présente invention permet de répondre aux besoins existants dans l'état de la technique.

L'invention est particulièrement utile pour la fabrication de composés piézoélectriques, ferroélectriques, pyroélectriques ou électroactifs.

### BREVE DESCRIPTION DES FIGURES

La **figure 1** représente un spectre RMN ¹H du terpolymère poly(VDF-*ter-*TrFE-*ter*-1234ze) dans l'acétone d-6 (référence 5, Tableau 1).
La **figure 2** représente un spectre RMN ¹⁹F du terpolymère poly(VDF-*ter-*TrFE-*ter*-1234ze) dans l'acétone d-6 (référence 5, Tableau 1).
La **figure 3** représente les spectres RMN ¹⁹F des terpolymères poly(VDF-*ter-*TrFE-*ter*-1234ze) dans l'acétone d-6, prélevés après 3 h (a), 4 h (b), 6 h (c) et 11 h (d) (référence 5, Tableau 1).
La **figure 4** est un diagramme représentant l'évolution de la pression à l'intérieur de l'autoclave lors de la terpolymérisation du VDF avec du TrFE et du 1234ze pour la référence 4 (Tableau 1).
La **figure 5** représente un thermogramme DSC d'un terpolymère poly(VDF-*ter*-TrFE-*ter*-1234ze) (référence 4, Tableau 1). Le thermogramme du bas correspond à la deuxième montée en température à 20 °C/min tandis que le thermogramme du haut correspond au refroidissement à 20 °C/min précédant cette montée en température.
La **figure 6** représente les courbes d'hystérésis D-E d'un terpolymère poly(VDF-*ter*-TrFE-*ter*-1234ze) (référence 1, Tableau 1) mis en forme de film. Le champ électrique varie de 25 MV/m à 150 MV/m en augmentant par palier de 25 MV/m.
La **figure 7** représente un spectre FTIR d'un terpolymère poly(VDF-*ter*-TrFE-*ter*-1234ze) (référence 5, Tableau 1).
La **figure 8** représente un thermogramme ATG, à 10 °C/min sous air, d'un terpolymère poly(VDF-*ter*-TrFE-*ter*-1234ze) (référence 5, Tableau 1).
La **figure 9** représente un spectre RMN ¹H du terpolymère poly(VDF-*ter-*TrFE-*ter*-1234yf) dans l'acétone d-6 (référence 8, Tableau 1).
La **figure 10** représente un spectre RMN ¹⁹F du terpolymère poly(VDF-*ter-*TrFE-*ter*-1234yf) dans l'acétone d-6 (référence 8, Tableau 1).
La **figure 11** représente les spectres RMN ¹⁹F des terpolymères poly(VDF-*ter-*TrFE-*ter*-1234yf) dans l'acétone d-6, prélevés après 2 h (a), 5 h (b), 7 h (c) et 21 h (d) (référence 8, Tableau 1).

### DESCRIPTION DE MODES DE REALISATION DE L'INVENTION

L'invention est maintenant décrite plus en détail et de façon non limitative dans la description qui suit.

L'invention a pour objet un terpolymère de fluorure de vinylidène (VDF), de trifluoroéthylène (TrFE) et de 1,3,3,3-tétrafluoropropène (appelé aussi HFO-1234ze ou 1234ze). Ce terpolymère présente une température de Curie inférieure à 90°C, de préférence inférieure à 76°C, mesurée par calorimétrie différentielle à balayage (DSC) au maximum de l'endotherme lors de la deuxième montée en température à 20 °C/min.

Ce terpolymère peut être obtenu par une réaction de terpolymérisation du VDF avec le TrFE et le 1234ze, selon la réaction suivante :

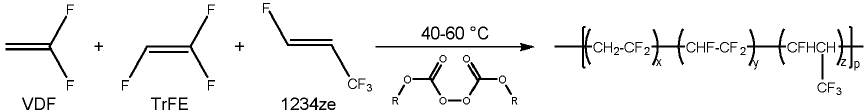

Selon un mode de réalisation, le terpolymère, selon l'invention, a la composition suivante (en moles) :
- une proportion de motifs issus du monomère fluorure de vinylidène (x) de 40 à 90 %, de préférence de 50 à 80 % ;
- une proportion de motifs issus du monomère trifluoroéthylène (y) de 5 à 50 %, de préférence de 10 à 40 % ; et
- une proportion de motifs issus du monomère 1,3,3,3-tétrafluoropropène (z) de 0,1 à 15 %, de préférence de 0,5 à 10 %.

Les terpolymères selon l'invention sont statistiques et linéaires. Avantageusement, ils possèdent une température de fusion inférieure à 146 °C, de préférence inférieure à 142 °C, mesurée par calorimétrie différentielle à balayage (DSC) au maximum de l'endotherme lors de la deuxième montée en température.

L'invention a également pour objet un procédé de préparation du terpolymère poly(VDF-*ter*-TrFE-*ter*-1234ze) comprenant une étape de terpolymérisation d'un mélange réactionnel de VDF, TrFE et 1234ze.

La réaction de terpolymérisation est effectuée en présence d'un amorceur radicalaire. Celui-ci peut être par exemple le peroxypivalate de tert-butyle (ou TBPPI), le peroxypivalate de tert-amyle, les peroxydicarbonates tel que le peroxydicarbonate de bis(4-*tert*-butyl cyclohexyl), les persulfates de sodium, d'ammonium ou de potassium, le peroxyde de benzoyle et ses dérivés, l'hydroxyperoxyde de *tert*-butyle, le peroxyde de *tert*-butyle ou le 2,5-bis(*tert*-butylperoxy)-2,5-diméthylhexane.

Selon le mode de réalisation, la terpolymérisation peut s'effectuer en présence d'un agent de dispersion. Celui-ci peut être par exemple un dérivé cellulosique hydrosoluble, tel que les alkyl celluloses ou les alkyl hydroxyalkyl celluloses, une paraffine, les alcools polyvinyliques.

Selon le mode de réalisation, la terpolymérisation peut s'effectuer en présence d'un agent de transfert de chaîne permettant de réguler la masse molaire du terpolymère. La régulation de la masse molaire permet notamment de faciliter la mise en oeuvre du terpolymère. Les agents régulateurs de masses molaires peuvent être par exemple les acétates d'alkyles tels que l'acétate d'éthyle, les carbonates de bisalkyle tels que le carbonate de diéthyle, les cétones telles que la butan-2-one, les thiols, les halogénures d'alkyle, les alcools saturés tels que l'isopropanol et les alcanes tels que le propane.

Selon un premier mode de réalisation, ledit terpolymère est préparé par un procédé de polymérisation radicalaire en solution, comprenant une étape de terpolymérisation d'un mélange réactionnel de fluorure de vinylidène, de trifluoroéthylène et de 1,3,3,3-tétrafluoropropène en présence d'un amorceur radicalaire dans un solvant.

Selon un mode de réalisation :
- la proportion molaire de VDF dans le mélange réactionnel est de 40 à 90 %, de préférence de 50 à 80 % ;
- la proportion molaire de TrFE dans le mélange réactionnel est de 5 à 50 %, de préférence de 10 à 40 % ; et
- la proportion molaire de 1234ze dans le mélange réactionnel est de 0,1 à 15 %, de préférence de 0,5 à 10 %,
les proportions molaires étant rapportées à la somme de moles de fluorure de vinylidène, de trifluoroéthylène et de 1,3,3,3-tétrafluoropropène.

Selon un mode de réalisation, le mélange réactionnel consiste essentiellement en, et de préférence consiste en, un mélange de fluorure de vinylidène, de trifluoroéthylène et de 1,3,3,3-tétrafluoropropène, d'amorceur radicalaire, et de solvant.

La réaction est effectuée dans un solvant, qui est par exemple choisi parmi le 1,1,1,3,3-pentafluorobutane, l'acétonitrile, la méthyléthylcétone, le diméthyl carbonate, le 2,2,2-trifluoroéthanol, l'hexafluoroisopropanol, l'acétate de méthyle, l'acétate d'éthyle, la cyclohexanone et les mélanges de ceux-ci.

Selon un mode de réalisation, le mélange réactionnel est chauffé jusqu'à une température de démarrage de réaction comprise entre 30 et 100 °C et de préférence entre 40 et 80°C. La pression initiale à l'intérieur de l'autoclave varie en fonction du solvant, de la température de la réaction et de la quantité de monomères. Elle est généralement comprise entre 0 à 80 bar. Le choix de la température optimale dépend de l'amorceur qui est utilisé. Généralement, la réaction est mise en oeuvre pendant au moins 6 heures, à une température à laquelle le temps de demi-vie de l'amorceur est compris entre 1 et 10 heures.

Selon un mode de réalisation préféré, la proportion molaire de motifs VDF dans le terpolymère est de 40 à 90 %, de préférence de 50 à 80 %.

Selon un mode de réalisation préféré, la proportion molaire de motifs TrFE dans le terpolymère est de 5 à 50 %, de préférence de 10 à 40 %.

Selon un mode de réalisation préféré, la proportion molaire de motifs 1234ze dans le terpolymère est de 0,1 à 15 %, de préférence de 0,5 à 10 %,

La masse molaire du terpolymère obtenu par polymérisation en solution est de préférence de 5.000 à 150.000 g/mol, plus préférentiellement de 10.000 à 100.000 g/mol.

L'indice de polymolécularité du terpolymère obtenu est de préférence de 1,5 à 3,5 plus préférentiellement de 1,8 à 3,0.

Selon un autre mode de réalisation, ledit terpolymère est préparé par un procédé de polymérisation radicalaire en suspension, comprenant une étape de terpolymérisation d'un mélange réactionnel de fluorure de vinylidène, de trifluoroéthylène et de 1,3,3,3-tétrafluoropropène en présence d'eau, d'un amorceur radicalaire, éventuellement d'un agent de dispersion et, éventuellement, d'un agent de transfert de chaîne.

Le procédé en suspension permet d'éviter l'utilisation de solvants toxiques et de tensio-actifs fluorés (type PFOA ou PFOS bio-cumulables, toxiques et persistants) lors de la synthèse et de la purification du terpolymère.

Ce procédé en suspension ne nécessite pas d'utilisation de mélange secondaire, à la différence de la synthèse en suspension de terpolymères poly(VDF-*ter*-TrFE-*ter-*CFE) ou de terpolymères poly(VDF-*ter*-TrFE-*ter*-CTFE) décrite dans le brevet WO 2014/091130 A1. Les trois monomères peuvent être introduits, en totalité, au début de la réaction. C'est un des avantages de l'utilisation de 1234ze comme termonomère, alors que d'autres termonomères testés comme le CFE et le CTFE doivent être injectés de manière continue dans le réacteur, augmentant la complexité du procédé de fabrication et donc les coûts de production.

Dans le procédé en suspension, le fluorure de vinylidène, le trifluoroéthylène et le 1,3,3,3-tétrafluoropropène sont chargés dans un réacteur agité contenant de l'eau déionisée, éventuellement un agent de dispersion et, éventuellement, un agent de transfert de chaîne.

Le réacteur est ensuite porté à la température d'amorçage souhaitée, cette température étant maintenue pendant la polymérisation à une valeur comprise entre 40 et 60°C. L'amorceur est ensuite injecté dans le réacteur pour démarrer la polymérisation. La consommation des monomères conduit à une diminution de pression qui est compensée par une alimentation en continue d'eau. La pression est ainsi maintenue dans une gamme allant de 80 à 110 bars. Le réacteur est ensuite refroidi et dégazé. Le produit est déchargé et récupéré sous la forme d'une suspension. Cette suspension est filtrée et la poudre humide est lavée puis séchée.

Le procédé de polymérisation en suspension est simplifié car il permet d'injecter en continu uniquement de l'eau pour maintenir la pression dans le réacteur.

La masse molaire du terpolymère obtenu par polymérisation en suspension est de préférence de 100.000 à 400.000 g/mol, plus préférentiellement de 150.000 à 300.000 g/mol.

Le terpolymère poly(VDF-*ter*-TrFE-*ter*-1234ze) préparé par le procédé selon l'invention présente des chaînes de composition homogène tout au long de la polymérisation et avec une distribution aléatoire en termonomère 1234ze le long de ces chaînes de polymère. Le terme "homogène" fait référence à l'absence de variation dans la composition des chaînes polymères. Autrement dit, dans le terpolymère selon l'invention toutes les chaînes ont la même composition. En revanche, le terpolymère poly(VDF-*ter*-TrFE-*ter*-1234yf) préparé par le procédé selon l'invention présente des chaînes de composition hétérogène tout au long de la polymérisation.

Les terpolymères obtenus possèdent des propriétés mécaniques suffisantes pour leur permettre de pouvoir être mis en forme de de films. Cette mise en forme de film peut se faire par exemple ; par extrusion ; par solvent-casting d'une solution de poly(VDF-*ter*-TrFE-*ter*-1234ze) dans un solvant organique; par spin-coating d'une solution de poly(VDF-*ter*-TrFE-*ter*-1234ze) dans un solvant organique. Les films ainsi obtenus, après une étape séchage puis une étape de recuit, possèdent de bonnes propriétés mécaniques et peuvent être étirés.

Les terpolymères poly(VDF-*ter*-TrFE-*ter*-1234ze) selon l'invention satisfont à plusieurs critères qui les qualifient comme des polymères électroactifs.

Les terpolymères poly(VDF-*ter*-TrFE-*ter*-1234ze) selon l'invention conservent un taux de cristallinité satisfaisant. Leur enthalpie de fusion, mesurée par calorimétrie différentielle à balayage (DSC) est supérieure à 5 J/g, de préférence à 8 J/g. En comparaison, les terpolymères poly(VDF-*ter*-TrFE-*ter*-CTFE) ont une enthalpie de fusion supérieure à 12 J/g, de préférence à 16 J/g.

Par ailleurs, les terpolymères poly(VDF-*ter*-TrFE-*ter*-1234ze) selon l'invention présentent une température de Curie inférieure à 90 °C, de préférence inférieure à 76 °C.

De plus, les terpolymères poly(VDF-*ter*-TrFE-*ter*-1234ze) selon l'invention présentent une polarisation à saturation à 150 MV/m supérieure à 30 mC/m², de préférence supérieure à 40 mC/m².

Les terpolymères, obtenus puis mis en forme, sont également utiles pour la fabrication de dispositifs piézoélectriques, ferroélectriques, pyroélectriques ou électroactifs ainsi que de revêtements.

### EXEMPLES

Les exemples suivants illustrent l'invention sans la limiter.

### Techniques et appareils de mesure

*Résonnance Magnétique Nucléaire (RMN).* Les spectres RMN sont enregistrés sur un appareil Bruker AC 400, l'acétone deutérée est utilisée comme solvant. Les constantes de couplage et les déplacements chimiques sont respectivement donnés en hertz (Hz) et en parties par million (ppm). Les paramètres d'acquisition pour la RMN ¹H [ou ¹⁹F] sont les suivants : angle de rotation 90° [30°], temps d'acquisition 4,5 s [0,7 s], séquence d'impulsion 2 s, nombre de scans 8 [128] et une durée de d'impulsion de 5 µs pour la RMN ¹⁹F.

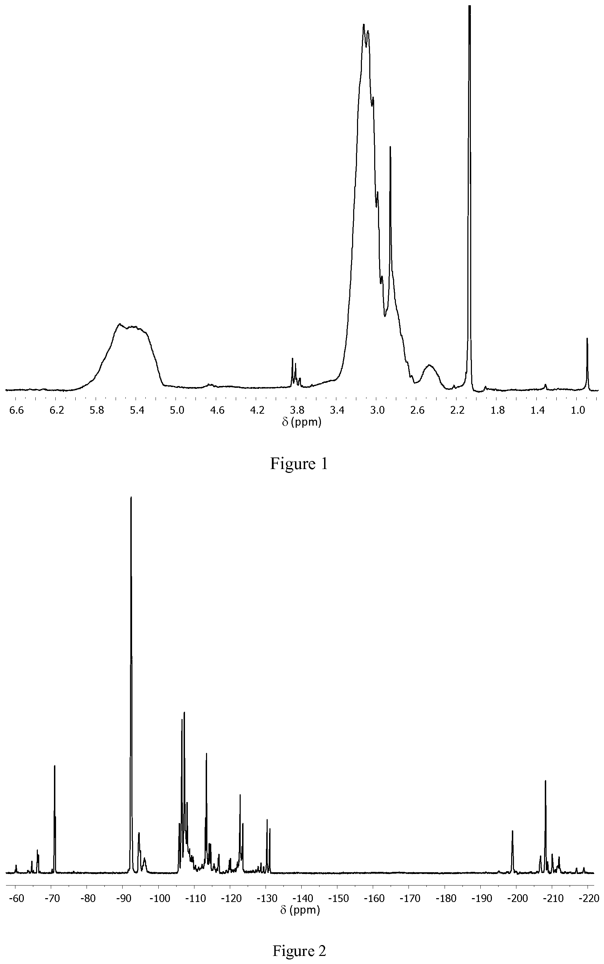

Le signal à 2,05 ppm observé dans la Figure 1 correspond aux protons résiduels dans l'acétone deutérée utilisée pour la RMN.

Le signal à 2,84 ppm observé dans la Figure 1 correspond à des traces d'humidité dans le solvant deutéré.

*Chromatographie d'Exclusion Stérique (CES).* Les analyses CES ont été réalisées sur un appareil Polymer Laboratories PL-GPC 50 Plus équipé de deux colonnes PL gel-mixed-C de 5 µm (gamme de masse molaire de 200 à 2.10⁶ g/mol) thermostatées à 35 °C. Un détecteur de variation d'indice de réfraction est utilisé. Le tétrahydrofurane (THF) est utilisé en tant qu'éluant (1,0 mL/min). L'étalonnage de l'appareil est réalisé avec des étalons de polystyrène (PS) et le toluène comme référence pour le débit. *Analyses Thermogravimétriques (ATG).* Les analyses ATG sont réalisées sur des échantillons de 10-15 mg sur un appareil TGA Q 50 de TA Instruments dans des coupelles en aluminium. La montée en température est réalisée à 10 °C/min, sous air entre 25 et 590 °C.

*Calorimétrie Différentielles à Balayage (DSC).* Les mesures DSC sont obtenues sur des échantillons de 10-15 mg sur un appareil Netzsch DSC 200 F3 en utilisant le cycle d'analyse suivant : refroidissement de la température ambiante à -50 °C à 20 °C/min, isotherme à -50 °C pendant 5 min, première montée de -50 à 200 °C à 10 °C/min, refroidissement de 200 à -50 °C à 10 °C/min, isotherme à -50 °C pendant 3 min, deuxième montée en température de -50 à 200 °C à 10 °C/min et dernier refroidissement de 200 °C à la température ambiante. L'étalonnage a été réalisé avec des métaux nobles et vérifié avec un échantillon d'Indium avant l'analyse. Les températures de transitions de Curie et de fusion sont déterminées au maximum des pics endothermiques lors de la deuxième montée en température.

*Spectroscopie Infrarouge (FTIR).* Les spectres FTIR ont été enregistrés sur un spectromètre Perkin-Elmer Spectrum 1000, équipé d'un module ATR, à 25 °C, avec une précision de ± 2 cm⁻¹.

### Exemple 1 : Terpolymérisation radicalaire en solution du VDF avec le TrFE et le 1234ze.

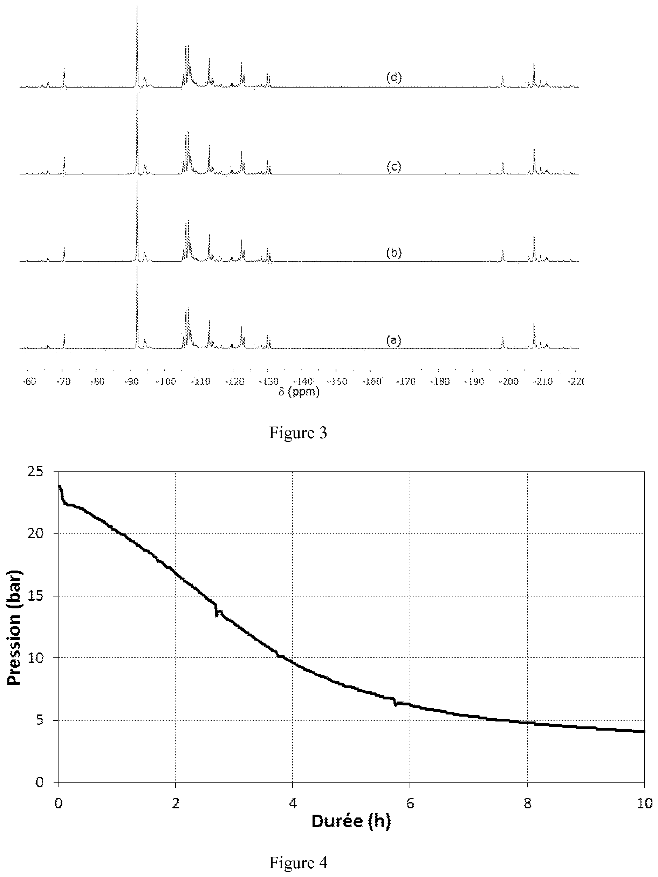

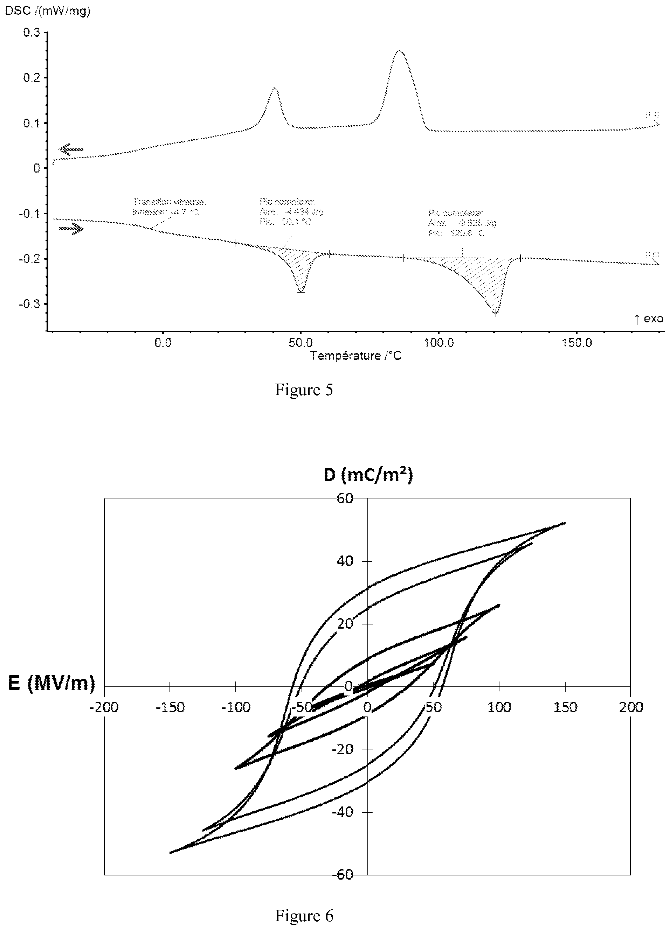

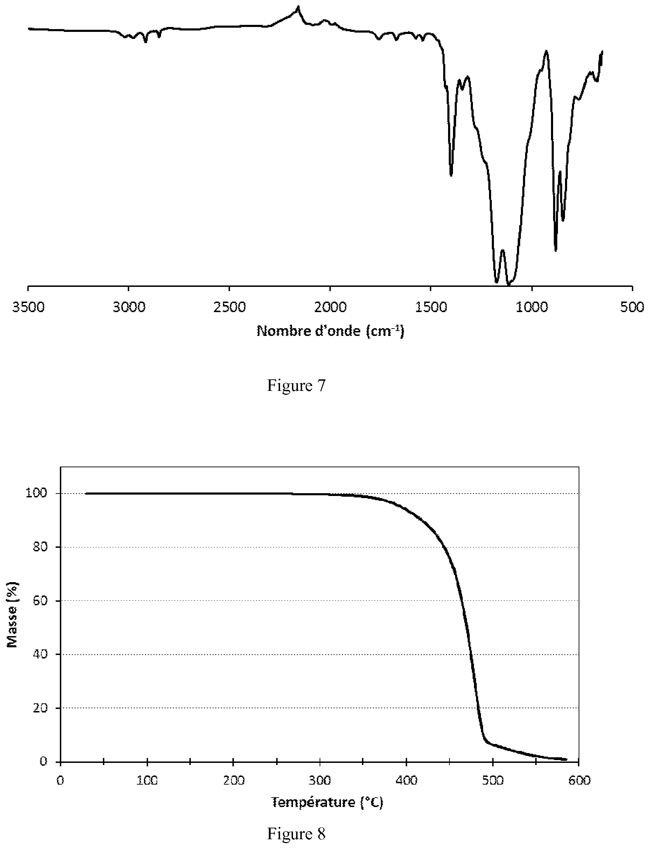

Un autoclave de 100 mL en Hastelloy est équipé avec des vannes d'entrée et de sortie, un disque de rupture, un manomètre et un capteur de pression relié à un ordinateur pour enregistrer l'évolution de la pression en fonction du temps (Figure 4). L'autoclave est pressurisé avec 30 bars d'azote afin de vérifier l'absence de fuites. Il subit ensuite trois cycles de vide-azote afin d'éliminer toute trace d'oxygène. Après l'inertage du réacteur, 60 mL d'une solution dégazée contenant du peroxydicarbonate de di(tert-butylcyclohexyle) (180 mg) dans le dimethylcarbonate (DMC) a été introduite dans le réacteur. Le réacteur est ensuite refroidi à -80 °C afin d'introduire les monomères gazeux. Le 1234ze (4,0 g, 35 mmol) puis le trifluoroéthylène (TrFE, 14,0 g, 171 mmol) et enfin le fluorure de vinylidène (VDF, 20,0 g, 313 mmol) sont transférés dans le réacteur par double pesée. Après avoir chargé tous les réactifs, l'autoclave est réchauffé à température ambiante puis chauffé à 48 °C. La réaction dure 14 heures et une chute de pression de 20 bar est observée sachant que celle en début de réaction était de 24 bar. Après réaction, le réacteur est placé dans un bain de glace et dégazé. Le brut réactionnel, visqueux et incolore, est transféré dans un bêcher et dilué dans 200 mL d'acétone. Cette solution est précipitée dans 4 L de pentane froid. Le produit obtenu, un solide blanc, est filtré puis séché à 60 °C sous vide pendant 14 heures. Le polymère obtenu (rendement de 85 %) est caractérisé par spectroscopie RMN ¹H (Figure 1) et ¹⁹F (Figure 2), CES, DSC (Figure 5), IR (Figure 7) et ATG (Figure 8).

La **figure 1** est un spectre RMN ¹H permettant d'observer les différents types de protons présents dans le terpolymère préparé selon la référence 5 du Tableau 1. On observe entre 5,1 et 6,1 ppm le massif caractéristique des protons des unités TrFE et du CHF de des unités 1234ze. Le massif entre 2,6 et 3,4 ppm correspond aux protons des CH₂ des unités VDF dans les enchaînements tête-queue et des CH(CF₃) des unités 1234ze. Le massif entre 2,3 et 2,6 ppm correspond aux protons des CH₂ des unités VDF dans les enchaînements queue-queue.

La **figure 2** est un spectre RMN ¹⁹F permettant d'observer les différents types d'atomes de fluor présents dans le terpolymère préparé selon la référence 5 du Tableau 1. Les signaux entre -60 et -72 ppm correspondent aux atomes de fluor des CF₃ des unités du 1234ze. Les signaux entre -90 et -133 ppm correspondent aux atomes de fluor des CF₂ des unités VDF et TrFE. Les signaux entre -195 et -220 ppm correspondent au CFH des unités TrFE et 1234ze.

Les figures 1 et 2 permettent de déterminer la microstructure (ou composition en unités VDF, TrFE et 1234ze) des terpolymères préparés selon les exemples 1 et 2.

La **figure 3** montre une succession de spectres RMN ¹⁹F de prélèvements au cours du temps. Les prélèvements ont été effectués après 3 h (a), 4 h (b), 6 h (c) et 11 h (d) de terpolymérisation. Tous les signaux des différents spectres ont la même intensité, notamment ceux à entre -58 et -73 ppm caractéristiques des unités 1234ze, confirmant ainsi l'incorporation homogène de 1234ze durant toute la terpolymérisation.

La **figure 4** illustre l'évolution de la pression à l'intérieur de l'autoclave lors de la terpolymérisation du VDF avec du TrFE et du 1234ze pour la référence 4 du Tableau 1. On observe une chute de pression immédiate dans palier. Il n'y a donc pas d'inhibition au début de la réaction. La pression finale est de 4 bars. Tous les monomères étant gazeux, cette faible pression indique une consommation presque totale de tous les monomères. Les conversions sont donc élevées.

La **figure 5** représente un thermogramme DSC d'un terpolymère poly(VDF-*ter*-TrFE-*ter*-1234ze) qui correspond à la référence 4 du Tableau 1. Le pic endothermique bien défini à 50 °C, correspondant à la transition de Curie, confirme la présence d'une phase électroactive ferroélectrique à T < 50 °C et d'une phase paraélectrique à T > 50 °C. La température de fusion de 121 °C est diminuée de presque 30 °C par rapport à un copolymère poly(VDF-*co*-TrFE) de rapport VDF/TrFE similaire. La diminution de la température de fusion et l'existence d'un seul endotherme de fusion confirment la distribution aléatoire en termonomère 1234ze le long des chaînes polymères ainsi que la composition homogène des chaines polymères poly(VDF-*ter*-TrFE-*ter*-1234ze) tout au long de la polymérisation.

La **figure 6** représente les courbes d'hystérésis D-E d'un terpolymère poly(VDF-*ter-*TrFE-*ter*-1234ze) qui correspond à la référence 1 du Tableau 1. Le champ électrique maximum varie de 25 MV/m à 150 MV/m en augmentant par palier de 25 MV/m.

La **figure 7** représente un spectre FTIR d'un terpolymère poly(VDF-*ter*-TrFE-ter-1234ze) (référence 5, Tableau 1). Les bandes de vibration de valence à 1288 et 850 cm⁻¹ sont caractéristiques de la conformation *all-trans* des chaines polymères et de la phase cristalline béta donnant les propriétés d'électroactivité.

La **figure 8** représente un thermogramme ATG, à 10 °C/min sous air, d'un terpolymère poly(VDF-*ter*-TrFE-*ter*-1234ze) (référence 5, Tableau 1). La température de dégradation, à 5 % de perte de masse, des terpolymères poly(VDF-*ter*-TrFE-*ter-*1234ze) est supérieure à 350 °C. Ils possèdent une très bonne stabilité thermique, comparable à celle des copolymères poly(VDF-co-TrFE). L'introduction homogène de 1234ze ne diminue pas la stabilité thermique.

### Exemple 2 : Terpolymérisation radicalaire en suspension du VDF avec le TrFE et le 1234ze dans un réacteur de 3 L.

71 g (0,62 mol) de 1234ze, 337 g (4,11 mol) de TrFE et 494 g (7,72 mol) de VDF sont chargés dans un réacteur agité de 3 L rempli avec 2000 g d'eau déionisée (DI) contenant de l'éther cellulosique en tant qu'agent de dispersion. Le réacteur est ensuite porté à la température d'amorçage souhaitée, cette température étant maintenue pendant la polymérisation à une valeur comprise entre 40 et 60 °C. L'amorceur peroxydicarbonate est ensuite injecté dans le réacteur pour démarrer la polymérisation. La consommation des monomères conduit à une diminution de pression qui est compensée par une alimentation en continue d'eau DI. La pression est ainsi maintenue dans une gamme allant de 80 à 110 bar. Après l'introduction de 610 g d'eau DI, l'injection est arrêtée. Le réacteur est ensuite refroidi et dégazé. Le produit est déchargé et récupéré sous la forme d'une suspension. Cette suspension est filtrée et la poudre humide est lavée à plusieurs reprises dans de l'eau DI. Enfin, la poudre est séchée dans une étuve à température modérée jusqu'à poids constant. 568 g de poudre sèche sont récupérés (rendement de 63 %). La composition molaire de VDF/TrFE/1234ze calculée par spectroscopie RMN ¹⁹F est de 62/34/4.

### Exemple Comparatif C1 : Terpolymérisation radicalaire en solution du VDF avec le TrFE et le 2,3,3,3-tétrafluoropropène (1234yf).

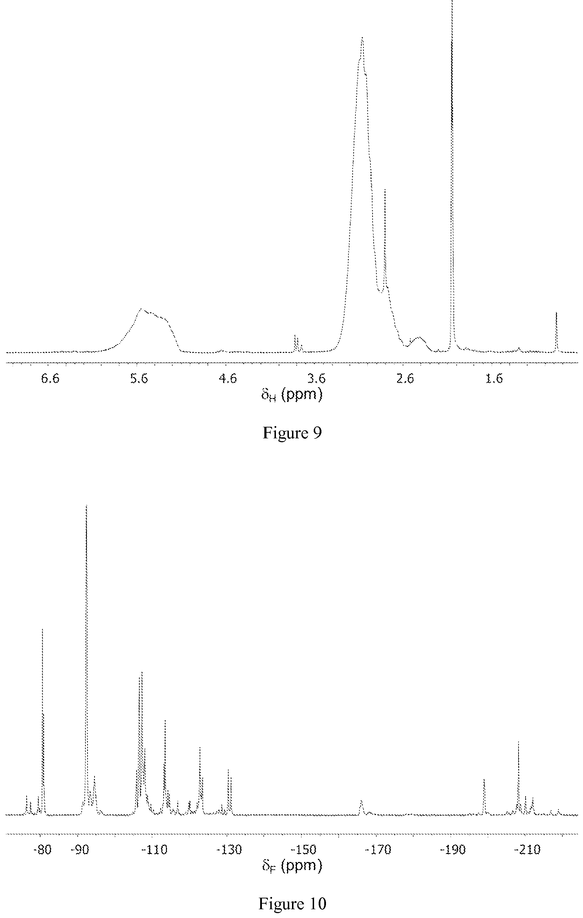

Un autoclave de 100 mL en Hastelloy est équipé avec des vannes d'entrée et de sortie, un disque de rupture, un manomètre et un capteur de pression relié à un ordinateur pour enregistrer l'évolution de la pression en fonction du temps. L'autoclave est pressurisé avec 30 bars d'azote afin de vérifier l'absence de fuites. Il subit ensuite trois cycles de vide-azote afin d'éliminer toute trace d'oxygène. Après l'inertage du réacteur, 60 mL d'une solution dégazée contenant du peroxydicarbonate de di(tert-butylcyclohexyle) (206 mg) dans le dimethylcarbonate (DMC) a été introduite dans le réacteur. Le réacteur est ensuite refroidi à -80 °C afin d'introduire les monomères gazeux. Le 1234yf (6,0 g ; 53 mmol) puis le TrFE (15,0 g ; 183 mmol) et enfin le VDF (21,5 g ; 336 mmol) sont transférés dans le réacteur par double pesée. Après avoir chargé tous les réactifs, l'autoclave est réchauffé à température ambiante puis chauffé à 48 °C. La réaction dure 20 heures et une chute de pression de 22 bar est observée sachant que celle en début de réaction était de 23 bar. Après réaction, le réacteur est placé dans un bain de glace et dégazé. Le brut réactionnel, visqueux et incolore, est transféré dans un bécher et dilué dans 200 mL d'acétone. Cette solution est précipitée dans 4 L de pentane froid. Le produit obtenu, un solide blanc, est filtré puis séché à 80 °C sous vide pendant 14 heures. Le polymère obtenu (rendement de 96 %) est caractérisé par spectroscopie RMN ¹H (Figure 9) et ¹⁹F (Figure 10), DSC (Tableau 1). La **figure 9** est un spectre RMN ¹H permettant d'observer les différents types de protons présents dans le terpolymère préparé selon la référence 8 du Tableau 1. On observe entre 5,1 et 6,1 ppm le massif caractéristique des protons des unités TrFE. Le massif entre 2,55 et 3.5 ppm correspond aux protons des CH₂ des unités VDF et 1234yf dans les enchaînements tête-queue VDF-VDF et VDF-1234yf. Le massif entre 2,3 et 2,55 ppm correspond aux protons des CH₂ des unités VDF dans les enchaînements queue-queue.

La **figure 10** est un spectre RMN ¹⁹F permettant d'observer les différents types d'atomes de fluor présents dans le terpolymère préparé selon la référence 8 du Tableau 1. Les signaux entre -65 et -72 ppm correspondent aux atomes de fluor des CF₃ des unités du 1234yf. Les signaux entre -90 et -133 ppm correspondent aux atomes de fluor des CF₂ des unités VDF et TrFE. Les signaux entre -163 et -172 ppm correspondent au CF(CF₃) des unités 1234yf. Les signaux entre -195 et -220 ppm correspondent au CFH des unités TrFE.

Les figures 9 et 10 permettent de déterminer la microstructure (ou composition en unités VDF, TrFE et 1234yf) des terpolymères préparés selon l'exemple C1.

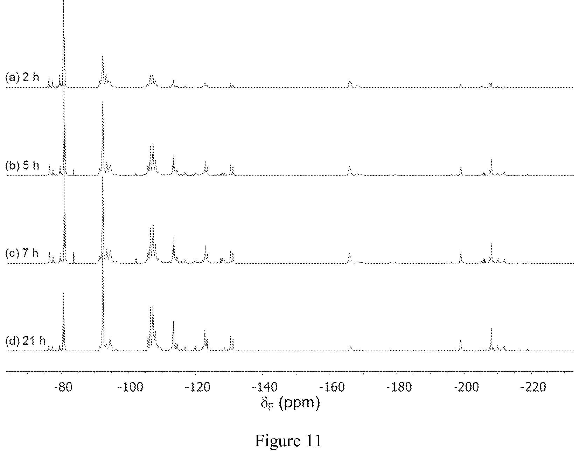

La **figure 11** montre une succession de spectres RMN ¹⁹F de prélèvements au cours du temps. Les prélèvements ont été effectués après 2 h (a), 5 h (b), 7 h (c) et 21 h (d) de terpolymérisation. On observe une forte variation d'intensité des différents signaux caractéristiques des unités VDF, TrFE ou 1234yf. Ceux autour de -80 ppm, attribués aux unités 1234yf, sont majoritaires après 2 h de terpolymérisation. Avec l'augmentation de la durée de la terpolymérisation, d'autres signaux deviennent plus intenses, notamment ceux autour de -92.4 ppm et -209 ppm, attribués aux unités VDF et TrFE. Ces variations indiquent que la composition moyenne en VDF/TrFE/1234yf des chaines de polymère n'est pas constante et au contraire varie en fonction de la durée de la polymérisation. Palier à cette hétérogénéité requiert la mise en place de procédés de polymérisation plus complexes et donc couteux comme l'injection différée d'un mélange de monomères dans le réacteur à la place de l'eau.

En revanche, la Figure 3 montre une composition homogène des terpolymères poly(VDF-*ter*-TrFE-*ter*-1234ze) tout au long de la polymérisation. On observe donc un comportement en polymérisation radicalaire différent entre le 1234ze et le 1234yf. Ces différences se retrouvent dans les propriétés thermiques des terpolymères. Un terpolymère poly(VDF-*ter*-TrFE-*ter*-1234ze) contenant 5 mol % du termonomère 1234ze possède une température de fusion de 115 °C. En revanche, un terpolymère poly(VDF-*ter*-TrFE-*ter*-1234yf) contenant 8 mol % du termonomère 1234yf possède une température de fusion supérieure (146 °C), proche de celle d'un copolymère poly(VDF-*co*-TrFE) de rapport VDF/TrFE similaire. Selon les modes de réalisation de l'invention, des teneurs comprises entre 0,1 à 15 mol % de termonomère 1234yf ne permettent pas de modifier de manière satisfaisante les propriétés thermiques et électroactives des terpolymères à base de VDF et de TrFE. Le 1234ze est donc une bonne alternative pour l'obtention de nouveaux terpolymères électroactifs dont les propriétés thermiques mesurées par DSC (températures de transition de Curie et de fusion) diffèrent de celles des terpolymères poly(VDF-*ter*-TrFE-*ter*-CFE), poly(VDF-*ter-*TrFE*-ter-*CTFE) et poly(VDF-*ter*-TrFE-*ter*-1234yf).

Le Tableau 1 suivant résume les conditions de ces terpolymérisations radicalaires du VDF avec le TrFE et le 1234ze ou le 1234yf et les propriétés thermiques des terpolymères obtenus.

Dans ce tableau, sont indiquées, pour chacune des 8 références ou échantillons de terpolymères préparés selon l'invention, les compositions molaires, du mélange de monomères au début de la réaction (première ligne, mesurée grâce à la perte de masse du réservoir de monomères), et du terpolymère synthétisé (la deuxième ligne, mesurée par spectroscopie RMN ¹⁹F).

T_{C} représente la température de Curie telle que déterminée par calorimétrie différentielle à balayage (DSC) au maximum de l'endotherme lors de la deuxième montée en température à 20 °C/min.

Tₘ représente la température de fusion du terpolymère, telle que déterminée par calorimétrie différentielle à balayage (DSC) au maximum de l'endotherme lors de la deuxième montée en température.

ΔHₘ représente l'enthalpie de fusion mesurée par calorimétrie différentielle à balayage (DSC) lors de la deuxième montée en température.

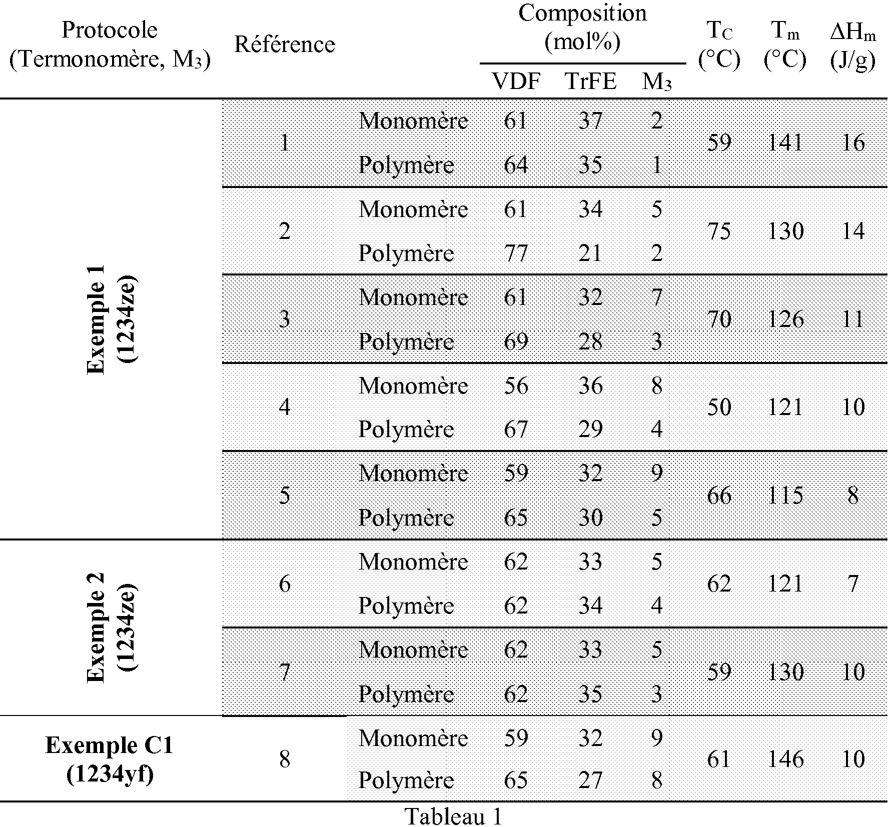

### Exemple 3: Préparation d'un film par solvent-casting

Afin de caractériser leurs propriétés physiques, des films de terpolymère (référence 2, Tableau 1) ont été préparés. 1,50 g de terpolymère sont dissous dans 5,00 g de méthyléthylcétone (MEK) à température ambiante. Après filtration, la solution visqueuse est coulée avec un couteau sur une plaque de verre et le solvant s'évapore à température ambiante et à pression atmosphérique pendant deux heures. Le film ainsi obtenu (épaisseur de 20 ±1 µm) est séché pendant 14 h à 80 °C puis recuit à 85 °C pendant 30 minutes.

Les films préparés à partir des terpolymères synthétisés selon les procédés décrits dans l'exemple 1 (polymérisation radicalaire en solution) ou de l'exemple 2 (polymérisation radicalaire en suspension) ont été caractérisés thermiquement par calorimétrie différentielle à balayage (DSC) qui donne accès à la température de transition de Curie, à la température de fusion ainsi qu'aux enthalpies de ces transitions (Tableau 1 et Figure 5). La présence d'une transition de Curie confirme l'existence d'une phase ferro-électrique électroactive dans le terpolymère. La température de fusion, diminuée par rapport à un copolymère poly(VDF-*co*-TrFE), prouve l'incorporation homogène des unités 1234ze le long de la chaine polymère. L'analyse thermogravimétrique (ATG) des films montre que l'introduction de 1234ze ne modifie pas la stabilité thermique des terpolymères qui restent stable sous air jusqu'à 350 °C. Les propriétés d'électroactivité des terpolymères ont été caractérisées grâce aux courbes de polarisation D-E qui permettent de déterminer la polarisation rémanente, la polarisation à saturation et le champ coercitif.

## Revendications

1. Terpolymère de fluorure de vinylidène (VDF), de trifluoroéthylène (TrFE) et de 1,3,3,3-tétrafluoropropène (1234ze), ledit terpolymère présentant une température de Curie inférieure à 90°C, mesurée par calorimétrie différentielle à balayage (DSC) au maximum de l'endotherme lors de la deuxième montée en température à 20 °C/min.

2. Terpolymère selon la revendication 1, ledit terpolymère étant statistique et linéaire.

3. Terpolymère selon la revendication 1 ou 2, dans lequel :
- la proportion molaire de motifs issus du monomère fluorure de vinylidène est de 40 à 90 %, de préférence de 50 à 80 % ;
- la proportion molaire de motifs issus du monomère trifluoroéthylène est de 5 à 50 %, de préférence de 10 à 40 % ; et
- la proportion molaire de motifs issus du monomère 1,3,3,3-tétrafluoropropène est de 0,1 à 15 %, de préférence de 0,5 à 10 %,

4. Terpolymère selon l'une des revendications 1 à 3 présentant une température de Curie inférieure à 76°C.

5. Procédé de préparation du terpolymère selon l'une des revendications 1 à 4 comprenant une étape de terpolymérisation d'un mélange réactionnel de VDF, TrFE et 1234ze.

6. Procédé selon la revendication 5, dans lequel :
- la proportion molaire de fluorure de vinylidène dans le mélange réactionnel est de 40 à 90 %, de préférence de 50 à 80 % ;
- la proportion molaire de trifluoroéthylène dans le mélange réactionnel est de 5 à 50 %, de préférence de 10 à 40 % ; et
- la proportion molaire de 1,3,3,3-tétrafluoropropène dans le mélange réactionnel est de 0,1 à 15 %, de préférence de 0,5 à 10 % ;
les proportions molaires étant rapportées à la somme de moles de fluorure de vinylidène, de trifluoroéthylène et de 1,3,3,3-tétrafluoropropène.

7. Procédé selon la revendication 5, dans lequel le mélange réactionnel de VDF, TrFE et de 1234ze est introduit en totalité au début de la terpolymérisation.

8. Procédé selon l'une des revendications 5 à 7, dans lequel ledit terpolymère est obtenu par une polymérisation radicalaire en solution, comprenant une étape de terpolymérisation dudit mélange réactionnel en présence d'un amorceur radicalaire et d'un solvant.

9. Procédé selon la revendication 8, dans lequel ledit solvant est choisi parmi le 1,1,1,3,3-pentafluorobutane, l'acétonitrile, la méthyléthylcétone, le diméthyl carbonate, le 2,2,2-trifluoroéthanol, l'hexafluoroisopropanol, l'acétate de méthyle, l'acétate d'éthyle, la cyclohexanone, et les mélanges de ceux-ci.

10. Procédé selon l'une des revendications 5 à 7, dans lequel ledit terpolymère est obtenu par une polymérisation radicalaire en suspension, comprenant une étape de terpolymérisation dudit mélange réactionnel en présence d'eau, d'un amorceur, éventuellement d'un agent de dispersion et, éventuellement, d'un agent de transfert de chaîne.

11. Procédé selon la revendication 10, dans lequel la pression dans le réacteur est maintenue constante par une injection d'eau.

12. Procédé selon l'une des revendications 5 à 11 dans lequel la composition en termonomère 1234ze dans les chaînes polymères est homogène durant toute la polymérisation.

13. Film ou membrane comprenant au moins un terpolymère selon l'une des revendications 1 à 4.

14. Dispositif piézoélectrique comprenant un film selon la revendication 13.

15. Dispositif ferroélectrique comprenant un film selon la revendication 13.

16. Dispositif pyroélectrique comprenant un film selon la revendication 13.

17. Dispositif électroactif comprenant un film selon la revendication 13.

18. Revêtement comprenant un film selon la revendication 13.

## Patentansprüche

1. Terpolymer aus Vinylidenfluorid (VDF), Trifluorethylen (TrFE) und 1,3,3,3-Tetrafluorpropen (1234ze), wobei dieses Terpolymer eine Curie-Temperatur von weniger als 90 °C ausweist, die mittels Dynamischer Differenzkalorimetrie (DDK) am endothermen Peak beim zweiten Temperaturanstieg auf 20 °C/min gemessen wird.

2. Terpolymer nach Anspruch 1, wobei das Terpolymer statistisch und linear aufgebaut ist.

3. Terpolymer nach Anspruch 1 oder 2, in dem:
- der Stoffmengenanteil der vom Vinylidenfluorid-Monomer abgeleiteten Einheiten 40 bis 90 %, vorzugsweise 50 bis 80 %, beträgt;
- der Stoffmengenanteil der vom Trifluorethylen-Monomer abgeleiteten Einheiten 5 bis 50 %, vorzugsweise 10 bis 40 %, beträgt; und
- der Stoffmengenanteil der vom 1,3,3,3-Tetrafluorpropen-Monomer abgeleiteten Einheiten 0,1 bis 15 %, vorzugsweise 0,5 bis 10 %, beträgt,

4. Terpolymer nach einem der vorstehenden Ansprüche 1 bis 3, das eine Curie-Temperatur von weniger als 76 °C aufweist.

5. Verfahren zur Herstellung des Terpolymers nach einem der vorstehenden Ansprüche 1 bis 4, umfassend einen Schritt zur Terpolymerisation eines Reaktionsgemischs aus VDF, TrFE und 1234ze.

6. Verfahren nach Anspruch 5, in dem:
- der Stoffmengenanteil von Vinylidenfluorid im Reaktionsgemisch 40 bis 90 %, vorzugsweise 50 bis 80 %, beträgt;
- der Stoffmengenanteil von Trifluorethylen im Reaktionsgemisch 5 bis 50 %, vorzugsweise 10 bis 40 %, beträgt; und
- der Stoffmengenanteil von 1,3,3,3-Tetrafluorpropen im Reaktionsgemisch 0,1 bis 15 %, vorzugsweise 0,5 bis 10 %, beträgt;
wobei die Stoffmengenanteile auf die Summe der Mole von Vinylidenfluorid, Trifluorethylen und 1,3,3,3-Tetrafluorpropen bezogen sind.

7. Verfahren nach Anspruch 5, in dem das Reaktionsgemisch aus VDF, TrFE und 1234ze vollständig zu Beginn der Terpolymerisation zugesetzt wird.

8. Verfahren nach einem der vorstehenden Ansprüche 5 bis 7, in dem dieses Terpolymer durch eine radikalische Polymerisation in Lösung erlangt wird, umfassend einen Schritt zur Terpolymerisation dieses Reaktionsgemischs in Gegenwart eines Radikalinitiators und eines Lösungsmittels umfasst.

9. Verfahren nach Anspruch 8, in dem dieses Lösungsmittel ausgewählt ist aus 1,1,1,3,3-Pentafluorbutan, Acetonitril, Methylethylketon, Dimethylcarbonat, 2,2,2-Trifluorethanol, Hexafluorisopropanol, Methylacetat, Ethylacetat, Cyclohexanon und Mischungen hiervon.

10. Verfahren nach einem der vorstehenden Ansprüche 5 bis 7, in dem dieses Terpolymer durch eine radikalische Polymerisation in Suspension hergestellt wird, das einen Schritt zur Terpolymerisation dieses Reaktionsgemischs in Gegenwart von Wasser, eines Initiators, eventuell eines Dispergiermittels, und eventuell eines Kettenübertragungsmittels umfasst.

11. Verfahren nach Anspruch 10, in dem der Druck im Reaktor durch Wassereinspritzung konstant gehalten wird.

12. Verfahren nach einem der vorstehenden Ansprüche 5 bis 11, in dem die 1234ze-Termonomer-Zusammensetzung in den Polymerketten während der gesamten Polymerisation homogen ist.

13. Folie oder Membran, umfassend mindestens ein Terpolymer nach einem der vorstehenden Ansprüche 1 bis 4.

14. Piezoelektrische Vorrichtung, umfassend eine Folie nach Anspruch 13.

15. Ferroelektrische Vorrichtung, umfassend eine Folie nach Anspruch 13.

16. Pyroelektrische Vorrichtung, umfassend eine Folie nach Anspruch 13.

17. Elektroaktive Vorrichtung, umfassend eine Folie nach Anspruch 13.

18. Beschichtung, umfassend eine Folie nach Anspruch 13.

## Claims

1. A vinylidene fluoride (VDF), trifluoroethylene (TrFE) and 1,3,3,3-tetrafluoropropene (1234ze) terpolymer, said terpolymer having a Curie temperature lower than 90°C, as measured by differential scanning calorimetry (DSC) at the maximum of the endotherm during the second temperature rise at the rate of 20°C/min.

2. The terpolymer according to claim 1, said terpolymer being statistical and linear.

3. The terpolymer according to claim 1 or 2, wherein:
- the molar proportion of units originating from the vinylidene fluoride monomer is 40 to 90%, preferably 50 to 80%;
- the molar proportion of units originating from the trifluoroethylene monomer is 5 to 50%, preferably 10 to 40%; and
- the molar proportion of units originating from the 1,3,3,3-tetrafluoropropene monomer is 0.1 to 15%, preferably 0.5 to 10%.

4. The terpolymer according to one of claims 1 to 3, having a Curie temperature lower than 76°C.

5. A process for preparing the terpolymer according to one of claims 1 to 4, comprising a step of terpolymerizing a reaction mixture of VDF, TrFE and 1234ze.

6. The process according to claim 5, wherein:
- the molar proportion of vinylidene fluoride in the reaction mixture is 40 to 90%, preferably 50 to 80%;
- the molar proportion of trifluoroethylene in the reaction mixture is 5 to 50%, preferably 10 to 40%; and
- the molar proportion of 1,3,3,3-tetrafluoropropene in the reaction mixture is 0.1 to 15%, preferably 0.5 to 10%;
the molar proportions being based on the sum of the moles of vinylidene fluoride, trifluoroethylene and 1,3,3,3-tetrafluoropropene.

7. The process according to claim 5, wherein the reaction mixture of VDF, TrFE and 1234ze is introduced in full at the beginning of the terpolymerization.

8. The process according to one of claims 5 to 7, wherein said terpolymer is obtained by radical solution polymerization comprising a step of terpolymerization of said reaction mixture in the presence of a radical initiator and of a solvent.

9. The process according to claim 8, wherein said solvent is chosen from 1,1,1,3,3-pentafluorobutane, acetonitrile, methyl ethyl ketone, dimethyl carbonate, 2,2,2-trifluoroethanol, hexafluoroisopropanol, methyl acetate, ethyl acetate, cyclohexanone and mixtures thereof.

10. The process according to one of claims 5 to 7, wherein said terpolymer is obtained by radical suspension polymerization comprising a step of terpolymerization of said reaction mixture in the presence of water, of an initiator, optionally of a dispersing agent, and optionally of a chain transfer agent.

11. The process according to claim 10, wherein the pressure in the reactor is kept constant by an injection of water.

12. The process according to one of claims 5 to 11, wherein the composition of 1234ze termonomer in the polymer chains is homogeneous throughout the polymerization.

13. Film or membrane comprising at least one terpolymer according to one of claims 1 to 4.

14. Piezoelectric device comprising a film according to claim 13.

15. Ferroelectric device comprising a film according to claim 13.

16. Pyroelectric device comprising a film according to claim 13.

17. Electroactive device comprising a film according to claim 13.

18. Coating comprising a film according to claim 13.
